# EUROPEAN PATENT APPLICATION

(11) **EP 3 401 763 A1**
(43) Date of publication of application: **14.11.2018**
(21) Application number: 18171706.7
(22) Date of filing: 10.05.2018
(51) Int. Cl.: G06F 3/01, H01L 27/20

(54) **MICRODOT ACTUATORS**

(30) Priority: 11.05.2017 US 201715592295
(71) Applicant: Immersion Corporation, San Jose, CA 95134 (US)
(72) Inventor: KHOSHKAVA, Vahid, Montreal, Québec H2W 2R2 (CA)
(74) Representative: McDougall, Robert Campbell

(57) **Abstract**

Examples of devices, systems, and methods for microdot actuation are disclosed. In one example, a plurality of microdot actuators (518, 520, 522) is bonded to a transparent display and each microdot actuator (518, 520, 522) is partially or fully transparent. In various examples, a microdot actuator can have a lateral size between 5 and 10 microns. As examples, a microdot actuator (518, 520, 522) may be a microdot electroactive polymer (EAP) actuator (400) or a microdot piezoceramic actuator (300).

## Description

### FIELD

The present application generally relates to microdot actuators.

### BACKGROUND

Traditional actuators are not transparent to visible light. In addition, traditional actuators may not have a uniform displacement or acceleration through a surface. Accordingly, a need exists for a microdot actuator that is transparent to visible light and/or that provides uniform displacement and/or acceleration through a surface.

### SUMMARY

Various examples are described for devices, systems, and methods for microdot actuators.

One example disclosed actuator array has a plurality of microdot actuators. In this example, each microdot actuator of the plurality of microdot actuators comprises: a first electrode; a second electrode; and a middle layer between the first electrode and the second electrode. The actuator array may be modified in any suitable way as disclosed herein, including, but not limited to, any one or more of the following features, taken in any combination. In some examples, a lateral size one or more of the microdot actuators is less than ten microns. A lateral size of each microdot actuator may be less than ten microns. In some examples, a lateral size of one or more of the microdot actuators is greater than 5 nanometers. A lateral size of each microdot actuator may be greater than 5 nanometers. In some examples, a lateral size of one or more of the microdot actuators is between 5 nanometers and 500 nanometers. A lateral size of each microdot actuator may be between 5 nanometers and 500 nanometers. In some examples, a lateral size of one or more of the microdot actuators is between 10 nanometers and 380 nanometers. A lateral size of each microdot actuator may be between 10 nanometers and 380 nanometers. In some examples, a lateral size of one or more of the microdot actuators is between 14 nanometers and 300 nanometers. A lateral size of each microdot actuator may be between 14 nanometers and 300 nanometers.

In examples, one or more of the microdot actuators is partially transparent (e.g., semi-transparent) to visible light. In examples, one or more of the microdot actuators is completely transparent to visible light. One or more of the microdot actuators can be manufactured using soft lithography in one example. In some examples, one or more of the microdot actuators may be manufactured using screen printing. In some examples, one or more of the microdot actuators is an electroactive polymer (EAP) actuator. Optionally, each microdot actuator is an electroactive polymer (EAP) actuator. In various examples, the middle layer in one or more of the microdot actuators has a polymer film. Optionally, the middle layer in each of the plurality of microdot actuators comprises a polymer film. In some examples, one or more of the microdot actuators is a piezoceramic actuator. Optionally, each microdot actuator is a piezoceramic actuator. In some examples, one or more of the microdot actuators is a macro-fiber composite (MFC) actuator. Each of the microdot actuators may be a macro-fiber composite (MFC) actuator.

In some examples, one or more of the microdot actuators has a top layer having a first electrode and a third electrode, a bottom layer having a second electrode and a fourth electrode, and a middle layer between the top layer and the bottom layer. In this example, the first electrode can have a first conductive interdigitated electrode pattern and the third electrode can have a third conductive interdigitated electrode pattern. The first electrode and the third electrode can be disposed within the top layer. In this example, the second electrode can have a second conductive interdigitated electrode pattern mirroring the first conductive interdigitated electrode pattern, and the fourth electrode can have a fourth conductive interdigitated electrode pattern mirroring the third conductive interdigitated electrode pattern. In this example, the second electrode and the fourth electrode can be disposed within the bottom layer. In some examples, the middle layer for one or more of the microdot actuators has a plurality of aligned piezoelectric macro-fibers. In examples, the plurality of aligned piezoelectric fibers is a plurality of rectangular ceramic rods.

In one example, a portable computing device has a transparent and flexible surface, a plurality of microdot actuators bonded to the transparent and flexible surface, and a processor in communication with the plurality of microdot actuators. The processor can be configured to determine one or more microdot actuators to actuate, generate a signal configured to cause the one or more microdot actuators to actuate, and output the signal to the one or more microdot actuators. The portable computing device may be modified in any suitable way as disclosed herein including, but not limited to, any one or more of the following, taken in any combination. The portable computing device may be, for example, a smartphone, a phablet, or a tablet. One or more of the microdot actuators can be an electroactive polymer (EAP) actuator. One or more of the microdot actuators can be a piezoceramic actuator. One or more of the microdot actuators can be a macro-fiber composite (MFC) actuator. Each microdot actuator of the plurality of microdot actuators may comprise an electroactive polymer (EAP) actuator. Optionally, each microdot actuator of the plurality of microdot actuators comprises a piezoceramic actuator. Each microdot actuator of the plurality of microdot actuators may comprise a macro-fiber composite (MFC) actuator. In examples, one or more of the microdot actuators has a lateral size of fewer than 380 nanometers. Optionally, a lateral size of each microdot actuator is fewer than 380 nanometers. In examples, one or more of the microdot actuators has a lateral size of at least 10 nanometers. Optionally, the lateral size of each microdot actuator is at least 10 nanometers. In some examples, one or more of the microdot actuators is partially or completely transparent to visible light. For example, one or more of the microdot actuators can be transparent to a user of the portable computing device. Optionally, each microdot actuator of the plurality of microdot actuators is transparent to a user of the portable computing device. In examples, the transparent and flexible surface is a display. In some examples, the processor is also in communication with the transparent and flexible surface. For example, the processor can also be in communication the transparent and flexible surface (e.g., a transparent and flexible display) and the processor can be configured to cause information to be displayed on the display.

These illustrative examples are mentioned not to limit or define the scope of this disclosure, but rather to provide examples to aid understanding thereof. Illustrative examples are discussed in the Detailed Description, which provides further description. Advantages offered by various examples may be further understood by examining this specification.

### BRIEF DESCRIPTION OF THE DRAWINGS

The patent or application file contains at least one drawing executed in color. Copies of this patent or patent application publication with color drawing(s) will be provided by the Office upon request and payment of the necessary fee.

The accompanying drawings, which are incorporated into and constitute a part of this specification, illustrate one or more certain examples and, together with the description of the example, serve to explain the principles and implementations of the certain examples.
Figure 1 shows an example actuator array of microdot actuators according to an example.
Figure 2 shows an example method of manufacturing microdot actuators for a target surface according to an example.
Figure 3 shows an example piezoceramic microdot actuator according to an example.
Figure 4 shows an example electroactive polymer (EAP) microdot actuator according to an example.
Figure 5 shows an example smartphone having a display and microdot actuators according to an example.
Figure 6A shows an example displacement field of a non-microdot actuator according to an example.
Figures 6B and 6C show example displacement fields of 18 small actuators according to an example.
Figure 7 shows an example display having microdot actuators with microfiber along certain microdots according to an example.

### DETAILED DESCRIPTION

Examples are described herein in the context of devices, systems, and methods for microdot actuators. Those of ordinary skill in the art will realize that the following description is illustrative only and is not intended to be in any way limiting. Reference will now be made in detail to implementations of examples as illustrated in the accompanying drawings. The same reference indicators will be used throughout the drawings and the following description to refer to the same or like items.

In the interest of clarity, not all of the routine features of the examples described herein are shown and described. It will, of course, be appreciated that in the development of any such actual implementation, numerous implementation-specific decisions must be made in order to achieve the developer's specific goals, such as compliance with application- and business-related constraints, and that these specific goals will vary from one implementation to another and from one developer to another.

### Illustrative Example of an Actuator Array with Microdot Actuators

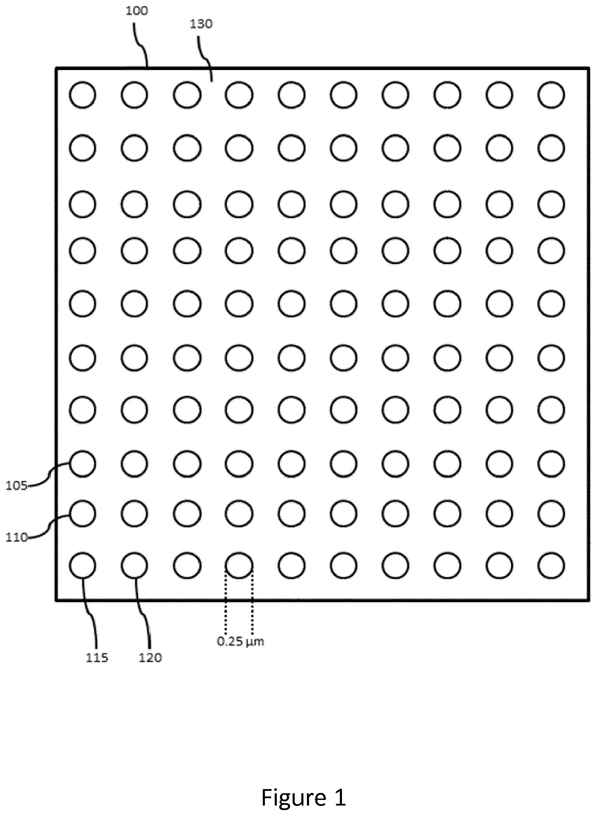

Referring now to Figure 1, this figure is a two-dimensional view of example actuator array 100 according to an example. In this example, actuator array 100 has a plurality of microdot actuators (105, 110, 115, 120, etc.), which when viewed perpendicular to the surface 130 are vertically and horizontally spaced apart throughout actuator array 100 and bonded to surface 130. A microdot actuator described herein refers to an actuator that does not have any dimension greater than 10 microns.

The actuator array 100 and the microdot actuators (105, 110, 115, 120, etc.) shown in Figure 1 are completely transparent to visible light. In Figure 1, each microdot actuator is an electroactive polymer (EAP) actuator and has a lateral size of 0.25 microns (250 nanometers) as shown by the dotted lines in Figure 1. In various examples, the microdot actuators can be piezoceramic actuators, piezopolymer actuators, smart material actuators, or a combination thereof.

In the example array shown in Figure 1, one or more of the microdot actuators (105, 110, 115, 120, etc.) can be bonded with surface 130. Surface 130 may be transparent and flexible. In some examples, surface 130 can be a transparent display and/or a flexible display. In some such examples, the transparent, flexible display and the actuator array 100 are both transparent to visible light. Thus, in some examples, the transparent and flexible surface 130 (such as a transparent and flexible display), the actuator array 100, and the microdot actuators (105, 110, 115, 120, etc.) are individually and/or collectively transparent to visible light and thus transparent actuation can be provided using the microdot actuators. Accordingly, in such examples, transparent microdot actuators can be used to actuate a transparent surface while maintaining transparency to visible light. In addition, the nanometer-scale size of the microdot actuators (105, 110, 115, 120, etc.) in various examples provides precise and uniform actuation to the transparent and flexible surface.

In some examples, a transparent microdot actuator has a lateral size approaching the range of visible light (e.g., approximately 0.75-1 micron) which allows light to pass through a transparent surface and/or the transparent microdot actuator for visibility. In other examples, a transparent microdot actuator has a lateral size of a few nanometers (e.g., between approximately 5 and 10 nanometers). In these examples, in addition to being transparent to visible light, such transparent microdot actuators can provide precise and uniform actuation to the transparent surface because of their nanometer lateral size.

The actuator array 100 shown in Figure 1 is square. In other examples, actuator array 100 can be any suitable shape such as a square, rectangle, circle, oval, etc. The microdot actuators (105, 110, 115, 120, etc.) shown in Figure 1 are circular. However, the term "dot" is not meant to be limiting. In other examples, one or more of the microdot actuators (105, 110, 115, 120, etc.) can be any suitable shape such as a square, rectangle, circle, oval, etc.

The microdot actuators (105, 110, 115, 120, etc.) shown in Figure 1 are equally spaced apart both horizontally and vertically throughout the surface 130 in the actuator array 100. Various other actuator layouts are possible. For example, in some examples, microdot actuators (105, 110, 115, 120, etc.) are substantially equally spaced apart horizontally or vertically throughout actuator array 100, or both. In other examples, one or more of the microdot actuators can be clustered together within part of actuator array 100. In some examples, microdot actuators can be aligned together to form one or more micro-line patterns. In such examples, the microdot actuators can be aligned side-by-side to form a straight micro-line, a curved micro-line, a circular micro-line, or another suitable micro-line.

In the example shown in Figure 1, surface 130 is the same size or approximately the same size as actuator array 100. However, in other examples, surface 130 is larger than actuator array 100. For example, surface 130 may be 5" by 5" and actuator array 100 may be 1" x 1". As another example, surface 130 may be 4" x 8" and numerous actuator arrays may be positioned throughout the surface 130 where each actuator array is 0.5" x 1". In other examples, any other suitable sizes of the surface 130 and the actuator array 100 can be used. In some examples, surface 130 is partially or completely transparent to visible light. In some examples, surface 130 is flexible. In examples, surface 130 is a display, such as a liquid crystal (LCD) display or organic light-emitting diode (OLED) display.

While the actuator array 100 and the microdot actuators (105, 110, 115, 120, etc.) shown in Figure 1 are completely transparent to visible light, in other examples, actuator array 100 and microdot actuators (105, 110, 115, 120, etc.) are at least partially transparent to visible light. For example, actuator array 100 and/or one or more of the microdot actuators (105, 110, 115, 120, etc.) can be at least partially visually transparent to a user of a portable computing device having actuator array 100 and microdot actuators (105, 110, 115, 120, etc.).

The microdot actuators (105, 110, 115, 120, etc.) shown in Figure 1 are each an electroactive polymer (EAP) actuator. In other examples, the microdot actuators (105, 110, 115, 120, etc.) can each be a piezopolymer actuator, a piezoceramic actuator, a smart material actuator, another suitable actuator, or a combination thereof. In yet further example, a combination of these types of actuator may make up the actuator array 100.

The microdot actuators (105, 110, 115, 120, etc.) shown in Figure 1 each has a lateral size of 0.25 microns (250 nanometers). In Figure 1, each of the microdot actuators is round and the lateral size of each microdot actuator is the diameter of the actuator (i.e., 0.25 microns in Figure 1). In other examples where a microdot actuator has a different shape (i.e., the microdot actuator is not round), the lateral size of a microdot actuator is the side-to-side width or side-to-side length of the actuator. In some examples, one or more of the microdot actuators (105, 110, 115, 120, etc.) has a lateral size of less than 1 micron (1,000 nanometers). In some examples, one or more of the microdot actuators (105, 115, 115, 120, etc.) has a lateral size greater than 5 nanometers. In some examples, one or more of the microdot actuators (105, 110, 115, 120, etc.) has a lateral size between 5 nanometers and 0.5 micron (500 nanometers). In some examples, one or more of the microdot actuators (105, 110, 115, 120, etc.) has a lateral size between 10 nanometers and 380 nanometers. In some examples, one or more of the microdot actuators (105, 110, 115, 120, etc.) has a lateral size between 14 nanometers and 300 nanometers.

The actuator array 100 and the microdot actuators (105, 110, 115, 120, etc.) shown in Figure 1 can be manufactured in any number of suitable ways. For example, in an example, actuator array 100 and/or one or more microdot actuators (105, 110, 115, 120, etc.) are manufactured using soft lithography. As another example, actuator array 100 and/or one or more microdot actuators (105, 110, 115, 120, etc.) can be manufactured using screen printing.

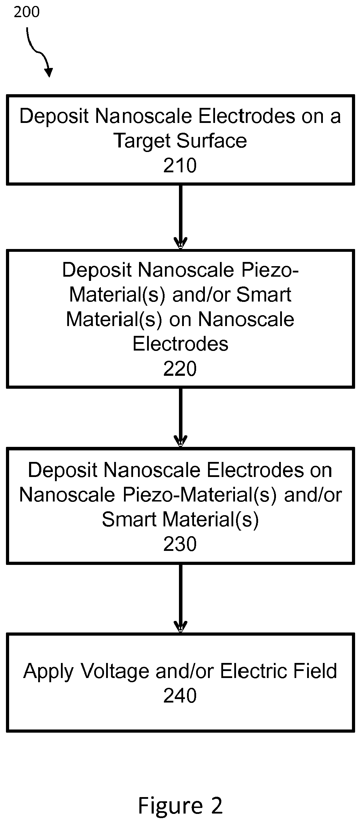

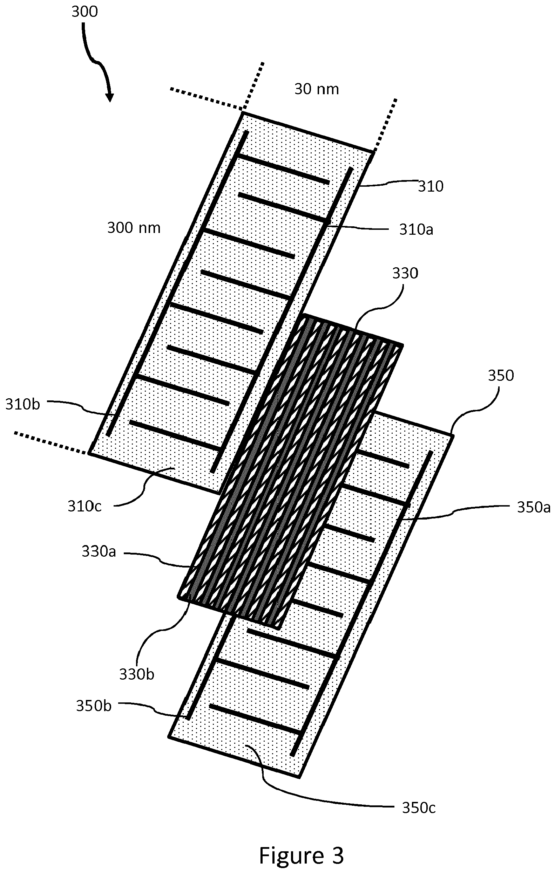

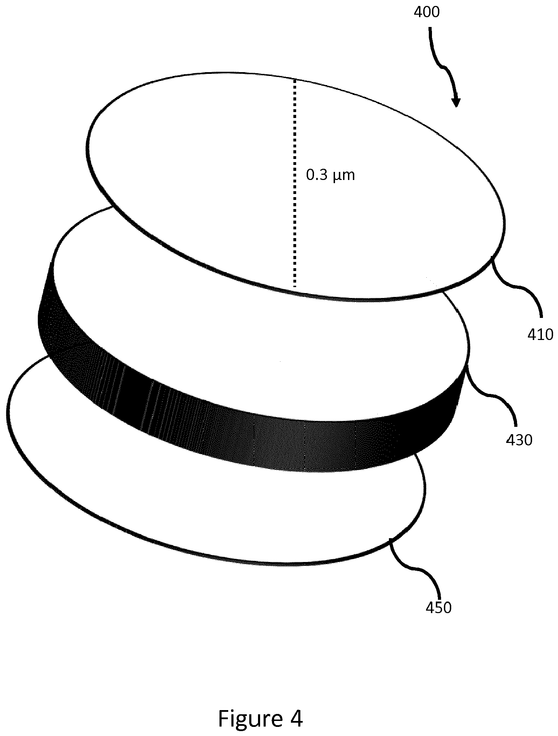

Referring now to Figure 2, this figure shows an example method 200 of manufacturing microdot actuators (such as microdot actuators 105, 110, 115, 120, etc.) for a target surface (such as a surface 130) according to an example. In describing method 200, reference will be made to Figures 1, 2, 3, and 4. Figure 3 shows an example piezoceramic microdot actuator according to an example. And Figure 4 shows an example electroactive polymer (EAP) microdot actuator according to an example. In other examples, the microdot actuator of Figure 4 can be an EAP microdot actuator.

Method 200 shown in Figure 2 begins in block 210 when nanoscale electrodes are deposited on a target surface. In examples, the target surface can be one or more surfaces discussed herein with respect to surface 130 in Figure 1. For example, the target surface may be a flexible surface, a transparent surface, a display (such as an LCD or OLED display), or a combination thereof.

The nanoscale electrodes deposited on the target surface can each have a lateral size corresponding to one or more of the microdots discussed herein. For example, a nanoscale electrode may have a lateral size of 250 nanometers. A nanoscale electrode can have a lateral size between a few nanometers (e.g., between approximately 5 and 10 nanometers) and 500 nanometers in various examples. The nanoscale electrodes can be any semiconductor or other conductive material, such as copper, aluminum, gold or silver. In examples, the nanoscale electrodes include one or more of the materials discussed herein with respect to electrodes 350a, 350b, and/or 450 shown in Figures 3 and 4, respectively.

The nanoscale electrodes can be deposited throughout the target surface or in particular region(s) of the target surface. For example, the nanoscale electrodes can be deposited in a matrix pattern as shown in Figure 1. In some examples, the nanoscale electrodes are deposited within particular regions of the target surface. For example, a first group of nanoscale electrodes can be deposited on a first region of the target surface and a second group of nanoscale electrodes can be deposited on a second region of the target surface. In various examples, the nanoscale electrodes can be deposited in any suitable region(s) and/or in any suitable pattern(s).

In an example, one or more of the nanoscale electrodes deposited on the target surface is a film layer having interdigitated electrodes, such as film layer 350 with electrically conductive interdigitated electrodes 350a and 350b in an electrically non-conductive material 350c as shown in Figure 3. In an example, one or more of the nanoscale electrodes deposited on the target surface is an electrode, such as electrode 450 shown in Figure 4.

Once the nanoscale electrodes are deposited on the target surface in block 210, the method 200 proceeds to block 220. In block 220, nanoscale piezo-material(s) and/or smart material(s) are deposited on the nanoscale electrodes deposited in block 210. In examples, the piezo-material(s) may be one or more piezoelectric polymers and/or one or more piezoelectric ceramics. In an example, one or more of the nanoscale piezo-material(s) deposited on the nanoscale electrodes from block 210 is a sheet 300 with a plurality of aligned piezoelectric macro-fibers 330a with epoxy 330b therebetween as shown in Figure 3. In some examples, one or more of the nanoscale smart material(s) deposited on the nanoscale electrodes from block 210 is an electroactive polymer (EAP) 430 as shown in Figure 4.

Once the nanoscale piezo-material(s) and/or smart material(s) are deposited on the nanoscale electrodes in block 220, the method 200 proceeds to block 230. In block 230, nanoscale electrodes are deposited on the piezo-materials and/or smart material(s) deposited in block 220.

The nanoscale electrodes deposited in block 230 can mirror the nanoscale electrodes deposited in block 210. For example, the nanoscale electrodes deposited in block 230 can have a lateral size that corresponds to a lateral size of the nanoscale electrodes deposited in block 210. In various examples, the nanoscale electrodes in block 230 can have a lateral size corresponding to one or more of the microdots discussed herein. As another example, the nanoscale electrodes can each have a lateral size between 5 nanometers and 500 nanometers in various examples. The nanoscale electrodes can be any semiconductor or other conductive material, such as copper, aluminum, gold or silver. In examples, the nanoscale electrodes include one or more of the materials discussed herein with respect to electrodes 310a, 310b, 410, and/or 450 shown in Figures 3 and 4, respectively.

In an example, one or more of the nanoscale electrodes deposited on the piezo-material(s) and/or smart material(s) is a film layer having interdigitated electrodes, such as film layer 310 with electrically conductive interdigitated electrodes 310a and 310b in an electrically non-conductive material 310c as shown in Figure 3. In an example, one or more of the nanoscale electrodes deposited on the piezo-material(s) and/or smart material(s) is an electrode, such as electrode 450 shown in Figure 4. In various examples, the nanoscale electrodes can be deposited in any suitable region(s) and/or in any suitable pattern(s).

Referring back to method 200 in Figure 2, in some examples, a polling mechanism may be required for the microdot actuators. For example, in some examples, a polling mechanism is used to align the electric dipoles of a piezoelectric material such as PZT-5 piezoelectric ceramic. In such examples, once the nanoscale electrodes have been deposited on the piezo-material(s) and/or smart material(s) in block 230, then the method 200 proceeds to block 240. In block 240, a voltage and/or an electric field are applied to align the electric dipoles of, for example, a piezoceramic material or a piezopolymer material. For example, a particular voltage and/or a particular electric field can be applied to the electrodes in situ (i.e., on-site) to pole a piezoelectric microdot actuator. In examples, a microdot actuator created in accordance with method 200 can provide uniform and consistent feedback. In examples, a microdot actuator created in accordance with method 200 can be used to actuate a transparent surface while at least partially or completely maintaining the transparency of the surface.

In various examples, one or more of the electrodes, piezo-material(s), and/or smart material(s) deposited in method 200 shown in Figure 2 is deposited using a screen printing technique. In some examples, one or more of the electrodes, piezo-material(s), and/or smart material(s) deposited in method 200 shown in Figure 2 is deposited using soft lithography.

In some examples, the nanoscale electrodes, piezo-material(s), and/or smart material(s) are deposited such that each of the manufactured microdot actuators are individually actuated. In other examples, the nanoscale electrodes, piezo-material(s), and/or smart material(s) are deposited such that two or more of the microdot actuators are actuated as a group. For example, in an example, every microdot actuator in an actuator array can be simultaneously actuated as a group. In other examples, two or more microdot actuators in actuator array, but not every microdot actuator in the actuator array, can be simultaneously actuated as a group.

Referring now to Figure 3, this figure shows an example of a microdot piezoceramic actuator according to an example. The microdot piezoceramic actuator is described herein with respect to a microdot macro-fiber composite (MFC) actuator; however, in various examples a microdot actuator can be any suitable piezoceramic actuator.

In Figure 3, microdot MFC actuator 300 has a film layer 310. Film layer 310 has an electrically non-conductive material 310c with electrically conductive interdigitated electrodes 310a and 310b therebetween. In Figure 3, a second side of film layer 310 is directly bonded to a first side of sheet 330. "Directly bonded" as used herein refers to bonding without an intermediary layer. For example, a second side of film layer 310 can be directly bonded to a first side of sheet 300 using an adhesive such that there is not an intermediate layer between film layer 310 and sheet 330.

In other examples, a second side of film layer 310 is indirectly bonded to a first side of sheet 330. "Indirectly bonded" as used herein refers to bonding where there is an intermediary layer. For example, a second side of film layer 310 can be directly bonded to another film layer (not shown in Figure 3) and a first side of sheet 330 can be directly bonded to this other film layer such that the other film layer is between the second side of film layer 310 and the first side of sheet 330, which is an example of film layer 310 being indirectly bonded to sheet 330.

In Figure 3, sheet 330 has a plurality of aligned piezoelectric macro-fibers 330a with epoxy 330b therebetween. In this figure, sheet 330 is directly bonded between film layer 310 and film layer 350. In this example, a first side of sheet 330 is directly bonded with a second side of film layer 310 and a second side of sheet 330 is directly bonded with a first side of film layer 350. In other examples, a first side of sheet 330 can be indirectly bonded with a second side of film layer 310 and/or a second side of sheet 330 can be indirectly bonded with a first side of film layer 350. For example, a second side of film layer 310 can be directly bonded to another layer (not shown in Figure 3) and the first side of sheet 330 may also be bonded to this other layer such that the other layer is between the second side of film layer 310 and the first side of sheet 330. As another example, a second side of sheet 330 can be directly bonded to another layer (not shown in Figure 3) and the first side of sheet 350 may also be bonded to this other layer such that the other layer is between the second side of sheet 330 and the first side of sheet 350.

Film layer 350 in microdot MFC actuator 300 has an electrically non-conductive material 350c with electrically conductive interdigitated electrodes 350a and 350b therebetween. Electrically conductive interdigitated electrode 350a can mirror electrically conductive interdigitated electrode 310a. Similarly, electrically conductive interdigitated electrode 350b can mirror electrically conductive interdigitated electrode 310b.

In examples, electrically conductive interdigitated electrodes 310a, 310b, 350a, and/or 350b are made of any suitable electrically conductive material including, but not limited to, copper, gold, silver, another electrically conductive material, or a combination thereof. In examples, electrically non-conductive materials 310c and/or 350c are made of any suitable electrically nonconductive material including, but not limited to, polyimide. The polyimide may be, Kapton, for example. One or more of the aligned piezoelectric macro-fibers 330a are made of any suitable fiber including, but not limited to, a piezoelectric material such as PZT-5 piezoelectric ceramic. Any suitable bonding material can be used for bonding. For example, DP-460 epoxy, urethane, acrylic, another suitable bonding material, or a combination thereof may be used in various examples. In one impediment, epoxy 305c, 315c, 325c, 330b, 335b, 345c, and/or 355c is DP-460 epoxy.

In Figure 3, the microdot MFC actuator 300 has a width of 30 nanometers and a length of 300 nanometers. In other examples, microdot MFC actuator 300 can have any number of suitable length or width. For example a microdot MFC actuator can have a width of less than 1 micron (1,000 nanometers) and a length of less than 1 micron (1,000 nanometers). In some examples, the microdot MFC actuator 300 has a width greater than 5 nanometers and a length greater than 5 nanometers. In some examples, a microdot MFC actuator has a width between 5 nanometers and 0.5 micron (500 nanometers) and a length between 5 nanometers and 0.5 micron (500 nanometers). In some examples, a microdot MFC actuator has a width and a length between 10 nanometers and 380 nanometers. In some examples, a microdot MFC actuator has a length and a width between 14 nanometers and 300 nanometers.

In some examples, a microdot MFC actuator can be bonded with a surface. For example, a second side of film layer 350 can be bonded with a surface in an example. The surface can be much larger than the microdot MFC actuator and numerous microdot MFC actuators can be bonded to the surface as described herein. For example, Figure 1 shows a surface with numerous microdot actuators bonded to the surface. The surface can be transparent and flexible. In some examples, the surface can be a transparent display and/or a flexible display. In examples, the transparent, flexible display and the microdot MFC actuator are transparent to visible light. In this way, in some examples, the transparent and flexible surface (such as a transparent and flexible display) and the microdot MFC actuator are individually and collectively transparent to visible light and thus transparent actuation can be provided using a microdot MFC actuator. In examples, a transparent microdot MFC actuator can be used to actuate a transparent surface while maintaining transparency to visible light. In addition, the nanometer-scale size of a microdot MFC actuators in various examples provide precise and uniform actuation to the transparent and flexible surface.

Referring now to Figure 4, this figure shows an example of a microdot electroactive polymer (EAP) actuator according to an example. In Figure 4, microdot EAP actuator 400 has an electroactive polymer 430 that is bonded to a first electrode 410 and a second electrode 450. In this example, a first side of electroactive polymer 430 is bonded to a second side of first electrode 410, and a second side of the electroactive polymer 430 is bonded to a first side of second electrode 450. In other examples, electroactive polymer 430 can be indirectly bonded to the first electrode 410 and the second electrode 450.

First electrode 410 and/or second electrode 450 can be made of any suitable electrically conductive material including, but not limited to, copper, gold, silver, another electrically conductive material, or a combination thereof. Electroactive polymer 430 can be any suitable electroactive polymer including, but not limited to, a polyvinylidene fluoride (PVDF), polyacetylene, an ionic polymer-metal composite, another electroactive polymer, or a combination thereof. In some examples, one or more piezoceramic materials and/or one or more smart materials may be used instead of electroactive polymer 430. In these examples, microdot actuator 400 can be a microdot piezoelectric actuator or a microdot smart material actuator instead of a microdot EAP actuator. In some examples, one or more piezoceramic materials and/or one or more smart materials can be used in addition to electroactive polymer 430.

In Figure 4, the microdot EAP actuator 400 has a diameter of 0.3 microns (300 nanometers). In other examples, a microdot EAP actuator 400 can have any number of suitable diameters, lengths, and/or widths. For example, a microdot EAP actuator can have a width of less than 1 micron (1,000 nanometers) and a length of less than 1 micron (1,000 nanometers). As another example, a microdot EAP actuator can have a diameter of less than 1 micron (1,000 nanometers). In some examples, a microdot EAP actuator 400 has a width greater than 5 nanometers and a length greater than 5 nanometers. In some examples, a microdot EAP actuator 400 has a diameter greater than 5 nanometers. In some examples, a microdot EAP actuator has a width between 5 nanometers and 0.5 micron (500 nanometers) and a length between 5 nanometers and 0.5 micron (500 nanometers). In some examples, a microdot EAP actuator has a diameter between 5 nanometers and 0.5 micron (500 nanometers). In some examples, a microdot EAP actuator has a length and width between 10 nanometers and 380 nanometers. In some examples, a microdot EAP actuator has a length and width between 14 nanometers and 400 nanometers. In some examples, a microdot EAP actuator has a length, width, and/or diameter of less than 10 microns.

In some examples, a microdot EAP actuator can be bonded with a surface. For example, a second side of second electrode 450 can be bonded with a surface in an example. The surface can be larger than the microdot EAP actuator and numerous microdot EAP actuators can be bonded to the surface as described herein. For example, Figure 1 shows a surface with numerous microdot actuators bonded to the surface. The surface can be transparent and flexible. In some examples, the surface can be a transparent display and/or a flexible display. In examples, the transparent, flexible display and the microdot EAP actuator are transparent to visible light. In this way, in some examples, the transparent and flexible surface (such as a transparent and flexible display) and the microdot EAP actuator are individually and collectively transparent to visible light and thus transparent actuation can be provided using a microdot EAP actuator. In examples, a transparent microdot EAP actuators can be used to actuate a transparent surface while maintaining transparency to visible light. In addition, the nanometer-scale size of microdot EAP actuators in various examples provide precise and uniform actuation to the transparent and flexible surface.

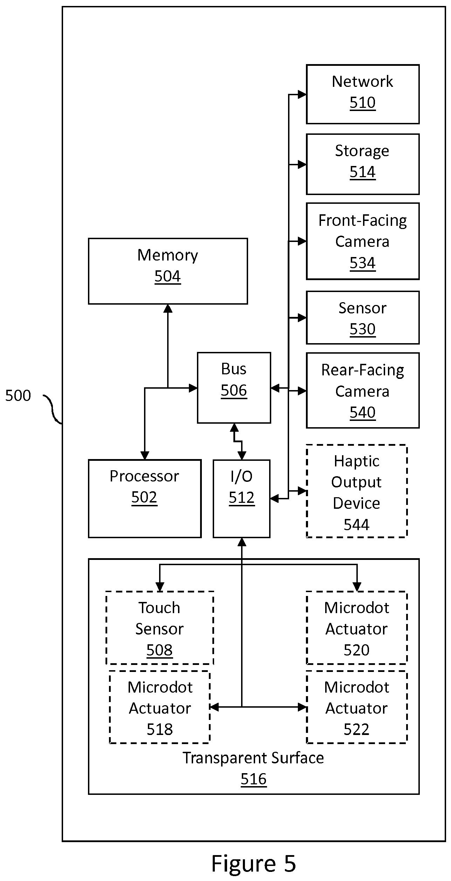

Referring now to Figure 5, this figure shows components of an example computing device 500 having a transparent surface 516 with microdot actuators (518, 520, 522) according to an example. The computing device 500 may comprise, for example, a smartphone, phablet, tablet, e-reader, portable gaming device, portable medical device, wearable device (e.g., arm strap, wrist band, ankle bracelet, watch, etc.). While computing device 500 is shown as a single device in Figure 5, in other examples, the computing device 500 may comprise multiple devices.

The example computing device 500 comprises a processor 502 interfaced with other hardware via bus 506. A memory 504, which can comprise any suitable tangible (and non-transitory) computer-readable medium such as RAM, ROM, EEPROM, or the like, may embody program components that configure operation of the computing device 500. For example, memory 504 can comprise one or more software applications that are configured to be executed by processor 502. The one or more software applications can be configured to cause computing device 500 provide haptic feedback using one or more of the microdot actuators (518, 520, 522).

In some examples, the computing device 500 may further comprise one or more network interface devices 510, input/output (I/O) interface components 512, and additional storage 514.

Network interface device 510 can represent one or more of any components that facilitate a network connection. Examples include, but are not limited to, wired interfaces such as Ethernet, USB, IEEE 1394, and/or wireless interfaces such as IEEE 802.11, Bluetooth, or radio interfaces for accessing cellular telephone networks (e.g., transceiver/antenna for accessing a CDMA, GSM, UMTS, or other mobile communications network).

I/O components 512 may be used to facilitate a connection to devices such as one or more displays, keyboards, cameras, mice, speakers, microphones, buttons, joysticks, and/or other hardware used to input data or output data. Additional storage 514 represents nonvolatile storage such as read-only memory, flash memory, random access memory (RAM), ferroelectric RAM (F-RAM), magnetic, optical, or other storage media included in the computing device 500 or coupled to processor 502.

The computing device 500 includes a transparent surface 516. In the example shown in Figure 5, the transparent surface 516 is integrated into computing device 500. In other example, the computing device 500 may be separate from the transparent surface 516. Transparent surface 516 represents any surface that is transparent to visible light. In examples, transparent surface 516 can be a flexible surface. In some examples, transparent surface 516 may be a display. For example, transparent surface 516 may be a liquid crystal (LCD) display or organic light-emitting diode (OLED) display. In some example, transparent surface 516 can be a thin, flexible surface. For example, in various examples where transparent surface 516 is a display, the display can be a thin, flexible display.

In computing device 500, transparent surface 516 has one or more touch sensors 508. In this example, transparent surface 516 is a touch-sensitive surface. In some examples, one or more touch sensors 508 are configured to detect a touch in a touch area when an object contacts transparent surface 516 and, in response, the one or more touch sensors 508 provide appropriate data for use by processor 502. Any suitable number, type, or arrangement of sensors can be used. For example, resistive and/or capacitive sensors may be embedded in transparent surface 516 and used to determine the location of a touch and other information, such as pressure, speed, and/or direction. As another example, optical sensors with a view of the transparent surface 516 may be used to determine the touch position. In some examples, transparent surface 516 does not have any touch sensors 508 and, in these examples, the transparent surface 516 is not touch-sensitive.

In other examples, the touch sensor 508 may comprise a LED (Light Emitting Diode) detector. For example, in some examples, transparent surface 516 may comprise a LED finger detector mounted on the side of a display. In some examples, the processor 502 is in communication with a single touch sensor 508. In other examples, the processor 502 is in communication with a plurality of touch sensors 508, for example, touch sensors associated with a first touch-screen and a second touch-screen. The touch sensor 508 is configured to detect user interaction, and based on the user interaction, transmit signals to processor 502. In some examples, touch sensor 508 may be configured to detect multiple aspects of the user interaction. For example, touch sensor 508 may detect the speed and pressure of a user interaction.

In computing device 500, transparent surface 516 has microdot actuators (518, 520, 522). In examples, the microdot actuators are throughout the transparent surface 516 in a pattern. For example, the microdot actuators can be throughout the surface in a matrix pattern. In some examples, the microdot actuators can be in various regions of the transparent surface 516. For example, microdot actuators 518 can be in one region of transparent surface 516 (such as a bottom-center of the transparent surface), microdot actuators 520 can be in another region of transparent surface 516 (such as a middle-left of the transparent surface), and microdot actuators 522 can be in yet another region of transparent surface 516 (such as a middle-right of the transparent surface). In this example, the microdot actuators (518, 520 and 522) are non-adjacent in transparent surface 516. In various examples, each of the microdot actuators (518, 520, 522) can be located in any suitable location within transparent surface 516. In some examples, one or more microdot actuators is adjacent to one or more other microdot actuators. In other examples, one or more microdot actuators is non-adjacent to one or more other microdot actuators.

In computing device 500, the microdot actuators (518, 520, 522) are in communication with processor 502 via I/O 512 and bus 506. In other examples, processor 502 is directly in communication with processor 502 or indirectly in communication with the processor via bus 506. In examples, the processor 502 controls each microdot actuator individually. For example, processor 502 sends a signal to a particular microdot actuator to cause that microdot actuator to actuate. In this example, processor 502 can send one or more signals to one or more of the microdot actuators to cause those microdot actuator(s) to actuate. In some examples, processor 502 sends a signal to a group of microdot actuators. For example processor 502 can send a signal to a group of microdot actuators within a particular region of transparent surface 516. In some examples, processor 502 can send a single signal to the group of microdot actuators to cause the group of microdot actuators to actuate. In other examples, processor 502 can send one or more signals to the microdot actuators within a particular region of transparent surface 516 to cause those microdot actuators to actuate.

One or more of the microdot actuators (518, 520, 522) can be any suitable microdot actuator, such as a microdot actuator (105, 110, 115, or 120) discussed herein with respect to Figure 1, an actuator array 100 with microdot actuators (105, 110, 115, or 120) discussed herein with respect to Figure 1, a macro-fiber composite (MFC) microdot actuator discussed herein with respect to Figure 3, an electroactive polymer (EAP) microdot actuator discussed herein with respect to Figure 4, another piezoceramic actuator, another piezoelectric actuator, a smartgel actuator, or a combination thereof. In some examples, one or more of the microdot actuators can be manufactured according to the method 200 described above with respect to Figure 2.

As discussed above, in some examples, computing device 500 may include a touch-enabled display that combines a transparent surface 516 and a display. The transparent surface 516 may correspond to the display exterior or one or more layers of material above components of the display. In other examples, transparent surface 516 may not comprise (or otherwise correspond to) a display, depending on the particular configuration of the computing device 500.

The computing device 500 also comprises one or more additional sensor(s) 540. The sensor(s) 540 are configured to transmit sensor signals to the processor 502. In some examples, the sensor(s) 540 may comprise, for example, a camera, humidity sensor, ambient light sensor, gyroscope, GPS unit, accelerometer, range sensor or depth sensor, biorhythm sensor, or temperature sensor. Although the example shown in Figure 5 depicts the sensor 540 internal to computing device 500, in some examples, the sensor 540 may be external to computing device 500. For example, in some examples, the one or more sensors 540 may be associated with a game controller for use with a computing device 500 comprising a game system. In some examples, the processor 502 may be in communication with a single sensor 540 and, in other examples, the processor 502 may be in communication with a plurality of sensors 540. In some examples, the sensor 540 may be remote from computing device 500, but communicatively coupled to processor 502.

Computing device 500 further includes haptic output device 544 in communication with the processor 502. The haptic output device 544 is configured to output a haptic effect in response to a haptic signal. In some examples, the haptic output device 544 is configured to output a haptic effect comprising, for example, a vibration, a change in a perceived coefficient of friction, a simulated texture, a change in temperature, a stroking sensation, an electro-tactile effect, or a surface deformation (e.g., a deformation of a surface associated with the computing device 500). Although a single haptic output device 544 is shown here, some examples may comprise multiple haptic output devices 544 of the same or different type that can be actuated in series or in concert to produce haptic effects.

In the example shown in Figure 5, the haptic output device 544 is internal to computing device 500. In other examples, the haptic output device 544 may be remote from computing device 500, but communicatively coupled to processor 502, for example, as shown in Figure 3. For instance, haptic output device 544 may be external to and in communication with computing device 500 via wired interfaces such as Ethernet, USB, IEEE 1394, and/or wireless interfaces such as IEEE 802.11, Bluetooth, or radio interfaces.

In some examples, the haptic output device 544 may be configured to output a haptic effect comprising a vibration. In some such examples, the haptic output device 544 may comprise one or more of a piezoelectric actuator, an electric motor, an electro-magnetic actuator, a voice coil, a shape memory alloy, an electro-active polymer, a solenoid, an eccentric rotating mass motor (ERM), or a linear resonant actuator (LRA).

In some examples, the haptic output device 544 may be configured to output a haptic effect modulating the perceived coefficient of friction on along a surface of the computing device 500 in response to a haptic signal. In some such examples, the haptic output device 544 may comprise an ultrasonic actuator. The ultrasonic actuator may comprise a piezo-electric material. An ultrasonic actuator may vibrate at an ultrasonic frequency, for example 20 kHz, increasing or reducing the perceived coefficient at the surface of transparent surface 516.

In some examples, the haptic output device 544 may use electrostatic attraction, for example by use of an electrostatic actuator, to output a haptic effect. The haptic effect may comprise a simulated texture, a simulated vibration, a stroking sensation, or a perceived change in a coefficient of friction on a surface associated with computing device 500 (e.g., transparent surface 516). In some examples, the electrostatic actuator may comprise a conducting layer and an insulating layer. The conducting layer may be any semiconductor or other conductive material, such as copper, aluminum, gold, or silver. The insulating layer may be glass, plastic, polymer, or any other insulating material. Furthermore, the processor 502 may operate the electrostatic actuator by applying an electric signal, for example an AC signal, to the conducting layer. In some examples, a high-voltage amplifier may generate the AC signal. The electric signal may generate a capacitive coupling between the conducting layer and an object (e.g., a user's finger or a stylus) near or touching the haptic output device 544. In some examples, varying the levels of attraction between the object and the conducting layer can vary the haptic effect perceived by a user.

The computing device 500 also includes a front-facing camera 534. For example, the front-facing camera 534 shown in Figures 5 points or faces towards a user of the computing device 500 when the computing device 500 is used by the user. The front-facing camera 534 is configured to communicate a video signal to processor 502. In some examples, the processor 502 is in communication with front-facing camera 534 via bus 506.

The computing device 500 also includes a rear-facing camera 540. For example, the rear-facing camera 540 shown in Figure 5 points or faces away from a user of the computing device 500 when the computing device 500 is used by the user. The rear-facing camera 540 is configured to communicate a video signal to processor 502. In some examples, the processor 502 is in communication with rear-facing camera 540 via bus 506.

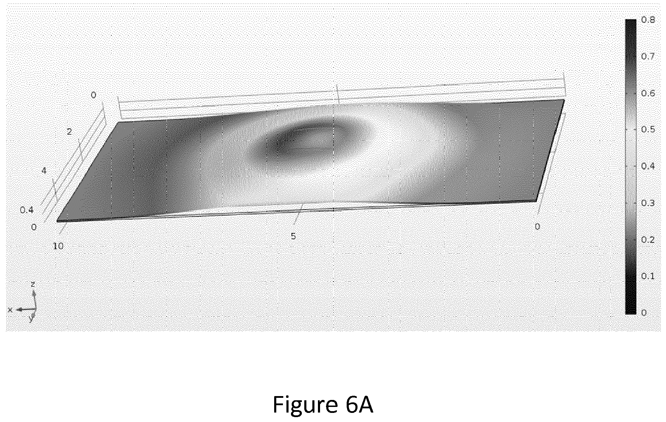

Referring now to Figure 6A, this figure shows an example displacement field of a non-microdot actuator. In this example, a 5" by 5" surface has been actuated using a 1" by 1" non-microdot actuator (such as a 1" by 1" non-microdot MFC actuator). Instead of using a single actuator as shown in Figure 6A, the same 5" by 5" surface can be actuated using numerous microdot actuators. In some examples, the size of an actuator array having the microdot actuators is comparable to the size of the single, non-microdot actuator (in Figure 6A, 1" by 1"). In this example, the actuator array can have numerous microdot actuators that have a lateral size between 5 nanometers and 1 micron. In some example, the microdot actuators can have a lateral size such that the microdot actuators are transparent to visible light. In examples, the actuator array may have one or more actuators that has a lateral size between 5 nanometers and 10 microns.

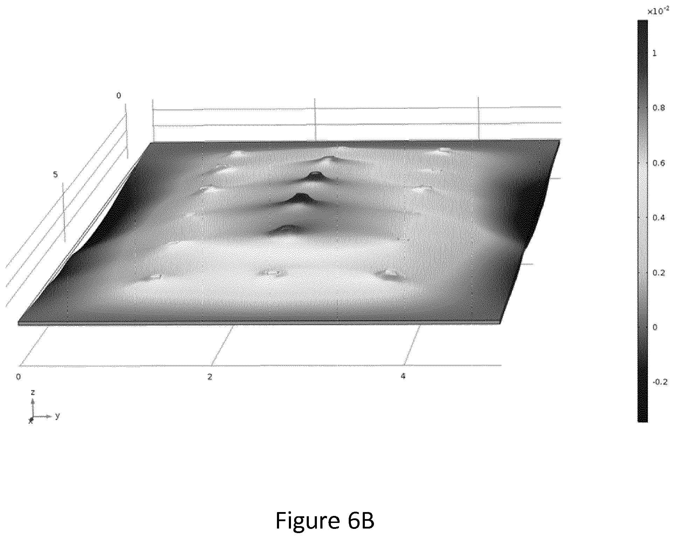

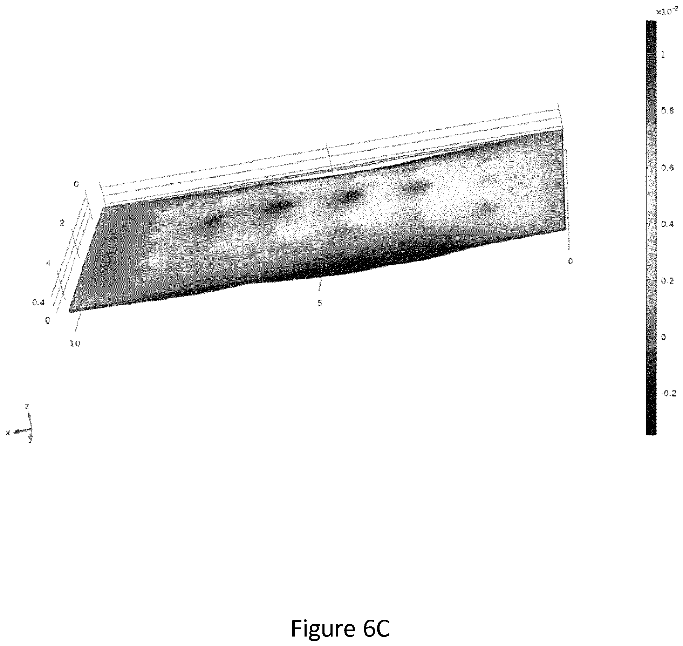

The example displacements shown in Figures 6B and 6C show example displacement fields of an actuator array having 18 small actuators. The actuator array with all 18 small actuators is comparable in size to the 1" by 1" non-microdot actuator used in Figure 6A. As can be seen in Figures 6A and 6B, the smaller actuators used in Figure 6A and 6B can actuate a greater surface area than the non-microdot actuator used in Figure 6A even though the overall size of the actuator array used in Figure 6B and Figure 6C, and the non-microdot actuator used in Figure 6A is comparable in size (e.g., both are 1" x by 1" in size).

The principle of using smaller actuators to actuate a larger surface area while keeping the overall surface area of the actuator array consistent can be extended to microdot actuators according to various examples. For example, instead of using only 18 actuators as used for the displacements shown in Figure 6B and 6C, the 1" x 1" actuator array could have a matrix of microdot actuators throughout the actuator array. In this example, each microdot actuator can be any number of suitable sizes ranging from 5 nanometers to 10 micron depending on the application. In some examples, the actuator array and each microdot actuator used in the array can be semi-transparent or completely transparent to visible light. In some examples, the actuator array and microdot actuators can be any suitable actuator array and microdot actuators, such as the actuator array discussed herein with respect to Figure 1 and/or the microdot actuators discussed herein with respect to Figures 1, 3, 4, and 5. In some examples, the actuator array and/or the microdot actuators can be manufactured according to method 200 discussed herein with respect to Figure 2.

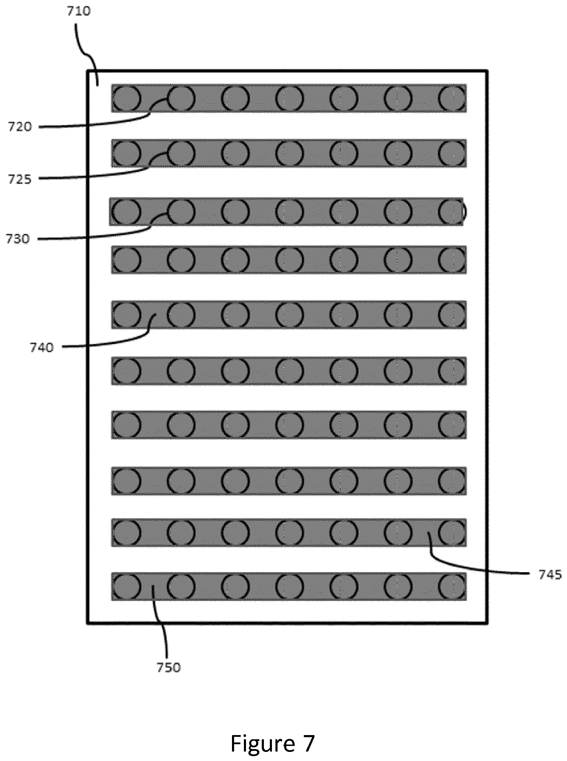

Referring now to Figure 7, this figure shows an example display 710 having microdot actuators (such as 720, 725, 730, etc.) with microfiber (740, 745, 750, etc.) along certain microdots actuators according to an example. Display 710 can be part of a computing device, such as smartphone 500 shown in Figure 5 or another computing device described herein. The microdot actuators (such as 720, 725, 730, etc.) shown in Figure 7 can be one or more of the microdot actuators described herein.

In Figure 7, the microdot actuators (such as 720, 725, 730, etc.) form an actuator array. The microdot actuators are aligned in rows and are spaced apart within each row. In this example, microfiber (such as 740, 745, 750, etc.) is aligned with the microdots in each row. In various examples, using microfiber with one or more microdots can improve the haptic performance of display 710.

While some examples of devices, systems, and methods herein are described in terms of software executing on various machines, the methods and systems may also be implemented as specifically-configured hardware, such as field-programmable gate array (FPGA) specifically to execute the various methods. For example, examples can be implemented in digital electronic circuitry, or in computer hardware, firmware, software, or in a combination thereof. In one example, a device may include a processor or processors. The processor comprises a computer-readable medium, such as a random access memory (RAM) coupled to the processor. The processor executes computer-executable program instructions stored in memory, such as executing one or more computer programs for editing an image. Such processors may comprise a microprocessor, a digital signal processor (DSP), an application-specific integrated circuit (ASIC), field programmable gate arrays (FPGAs), and state machines. Such processors may further comprise programmable computing devices such as PLCs, programmable interrupt controllers (PICs), programmable logic devices (PLDs), programmable read-only memories (PROMs), electronically programmable read-only memories (EPROMs or EEPROMs), or other similar devices.

Such processors may comprise, or may be in communication with, media, for example computer-readable storage media, that may store instructions that, when executed by the processor, can cause the processor to perform the steps described herein as carried out, or assisted, by a processor. Examples of computer-readable media may include, but are not limited to, an electronic, optical, magnetic, or other storage device capable of providing a processor, such as the processor in a web server, with computer-readable instructions. Other examples of media comprise, but are not limited to, a floppy disk, CD-ROM, magnetic disk, memory chip, ROM, RAM, ASIC, configured processor, all optical media, all magnetic tape or other magnetic media, or any other medium from which a computer processor can read. The processor, and the processing, described may be in one or more structures, and may be dispersed through one or more structures. The processor may comprise code for carrying out one or more of the methods (or parts of methods) described herein.

Examples of methods disclosed herein may be performed in the operation of computing devices. The order of the blocks presented in the examples above can be varied-for example, blocks can be re-ordered, combined, and/or broken into sub-blocks. Certain blocks or processes can be performed in parallel. Thus, while the steps of methods disclosed herein have been shown and described in a particular order, other examples may comprise the same, additional, or fewer steps. Some examples may perform the steps in a different order or in parallel. In some examples, one or more steps in a method described herein may be optional.

The foregoing description of some examples has been presented only for the purpose of illustration and description and is not intended to be exhaustive or to limit the disclosure to the precise forms disclosed. Numerous modifications and adaptations thereof will be apparent to those skilled in the art without departing from the spirit and scope of the disclosure.

Reference herein to an example or implementation means that a particular feature, structure, operation, or other characteristic described in connection with the example may be included in at least one implementation of the disclosure. The disclosure is not restricted to the particular examples or implementations described as such. The appearance of the phrases "in one example," "in an example," "in one implementation," or "in an implementation," or variations of the same in various places in the specification does not necessarily refer to the same example or implementation. Any particular feature, structure, operation, or other characteristic described in this specification in relation to one example or implementation may be combined with other features, structures, operations, or other characteristics described in respect of any other example or implementation.

## Claims

1. An actuator array (100) comprising:
a plurality of microdot actuators (105, 110, 115, 120), each microdot actuator (105, 110, 115, 120) of the plurality of microdot actuators (105, 110, 115, 120) comprising:
a first electrode (310a, 410);
a second electrode (350a, 450); and
a middle layer (330) between the first electrode (310a, 410) and the second electrode (350a, 450).

2. The actuator array (100) of claim 1, wherein a lateral size of each microdot actuator (105, 110, 115, 120) is less than 10 microns.

3. The actuator array (100) of claim 2, wherein the lateral size of each microdot actuator (105, 110, 115, 120) is greater than 5 nanometers, optionally between 5 nanometers and 500 nanometers, further optionally between 10 nanometers and 380 nanometers and, further optionally, between 14 nanometers and 300 nanometers.

4. The actuator array (100) of any preceding claim, wherein each microdot actuator (105, 110, 115, 120) is semi-transparent to visible light, or completely transparent to visible light.

5. The actuator array (100) of any preceding claim, wherein each microdot actuator (105, 110, 115, 120) is an electroactive polymer (EAP) actuator (400).

6. The actuator array (100) of claim 5, wherein the middle layer (330) in each of the plurality of microdot actuators (105, 110, 115, 120) comprises a polymer film.

7. The actuator array (100) of any one of claims 1 to 4, wherein each microdot actuator (105, 110, 115, 120) is a piezoceramic actuator (300).

8. The actuator array (100) of claim 7, wherein each microdot actuator (105, 110, 115, 120) further comprises:
a third electrode (310b); and
a fourth electrode (350b),
wherein the first electrode (310a) comprises a first conductive interdigitated electrode pattern, the third electrode (310b) comprises a third conductive interdigitated electrode pattern, and the first electrode (310a) and the third electrode (310b) are disposed within a top layer (310),
wherein the second electrode (350a) comprises a second conductive interdigitated electrode pattern mirroring the first conductive interdigitated electrode pattern, the fourth electrode (350b) comprises a fourth conductive interdigitated electrode pattern mirroring the third conductive interdigitated electrode pattern, and the second electrode (350a) and the fourth electrode (350b) are disposed within a bottom layer (350), and
wherein the middle layer (330) comprises a plurality of aligned piezoelectric macro-fibers (330a).

9. The actuator array (100) of claim 8, wherein the plurality of aligned piezoelectric fibers (330a) comprises a plurality of rectangular ceramic rods.

10. A portable computing device (500) comprising:
a transparent and flexible surface (516);
a plurality of microdot actuators (518, 520, 522) bonded to the transparent and flexible surface (516); and
a processor (502) in communication with the plurality of microdot actuators (518, 520, 522), wherein the processor (502) is configured to:
determine one or more microdot actuators (518, 520, 522) to actuate;
generate a signal configured to cause the one or more microdot actuators (518, 520, 522) to actuate; and
output the signal to the one or more microdot actuators (518, 520, 522).

11. The portable computing device (500) of claim 10, wherein the portable computing device (500) is at least one of a smartphone, a phablet, or a tablet.

12. The portable computing device (500) of claim 10 or claim 11, wherein each microdot actuator (518, 520, 522) of the plurality of microdot actuators (518, 520, 522) comprises an electroactive polymer (EAP) actuator (400) or a piezoceramic actuator (300).

13. The portable computing device (500) of claim 12, wherein a lateral size of each microdot actuator (518, 520, 522) is fewer than 380 nanometers and, optionally, at least 10 nanometers.

14. The portable computing device (500) of any one of claims 10 to 13, wherein the plurality of microdot actuators (518, 520, 522) are transparent to a user of the portable computing device (500).

15. The portable computing device (500) of claim 10, wherein the transparent and flexible surface (516) is a flexible display.
